# EUROPÄISCHE PATENTSCHRIFT

(11) **EP 3 660 877 B1**
(45) Veröffentlichungstag und Bekanntmachung des Hinweises auf die Patenterteilung: **03.01.2024**
(21) Anmeldenummer: 19205405.4
(22) Anmeldetag: 25.10.2019
(51) Int. Cl.: H01H 37/04, H01H 37/54, H05K 3/30, H01H 37/72, H05K 1/18, H05K 3/34, H01H 1/58

(54) **VORRICHTUNG UMFASSEND EINEN TEMPERATURABHÄNGIGEN SCHALTER UND EINE METALLENE MONTAGEKAPPE**
DEVICE COMPRISING A TEMPERATURE-DEPENDENT SWITCH AND A METAL MOUNTING CAP
DISPOSITIF COMPRENANT COMMUTATEUR DÉPENDANT DE LA TEMPÉRATURE ET UN CAPUCHON DE MONTAGE MÉTALLIQUE

(30) Priorität: 28.11.2018 DE 102018130078; 07.06.2019 WO PCT/EP2019/064926
(43) Veröffentlichungstag der Anmeldung: 03.06.2020
(73) Patentinhaber: Hofsaess, Marcel P., 99707 Kyffhäuserland Ortsteil Steintahleben (DE)
(72) Erfinder: Hofsaess, Marcel P., 99707 Kyffhäuserland Ortsteil Steintahleben (DE)
(74) Vertreter: Witte, Weller & Partner Patentanwälte mbB

(56) Entgegenhaltungen:
- EP-A1- 3 136 416
- EP-A1- 3 270 401
- DE-A1-102014 116 888
- JP-A- S52 103 684
- US-A- 3 414 225
- US-A1- 2003 034 872
- US-A1- 2010 090 793
- US-A1- 2014 167 907

## Beschreibung

Die vorliegende Erfindung betrifft eine Vorrichtung gemäß dem Oberbegriff des Anspruchs 1. Die Vorrichtung umfasst einen temperaturabhängigen Schalter mit einem Gehäuse, das eine Oberseite und eine dazu quer verlaufende Außenseite umfasst, mit zumindest einer auf der Oberseite angeordneten ersten äußeren Kontaktfläche, zumindest einer außen an dem Gehäuse angeordneten zweiten äußeren Kontaktfläche, und mit einem in dem Gehäuse angeordneten temperaturabhängigen Schaltwerk, das in Abhängigkeit von seiner Temperatur eine elektrisch leitende Verbindung zwischen der ersten und der zweiten äußeren Kontaktfläche herstellt oder öffnet. Die Vorrichtung umfasst ferner eine metallene Montagekappe, in der das Gehäuse aufgenommen ist, wobei die Montagekappe eine Wand aufweist, deren oberer Rand die Oberseite des Gehäuses überragt, und deren Innenseite zumindest teilweise an der Außenseite anliegt.

Eine Vorrichtung gemäß dem Oberbegriff des Anspruchs 1 ist aus der
US 2014/167907 A1 bekannt. Eine weitere bespielhafte Vorrichtung ist aus der
US 2003/0034872 A1 bekannt. Ein Schalter der oben genannten Art ist ferner aus der DE 196 23 570 A1 bekannt.

Der bekannte temperaturabhängige Schalter dient in an sich bekannter Weise dazu, die Temperatur eines Gerätes zu überwachen. Dazu wird er bspw. über eine seiner Außenflächen in thermischen Kontakt mit dem zu schützenden Gerät gebracht, so dass die Temperatur des zu schützenden Gerätes die Temperatur des Schaltwerks beeinflusst.

Der Schalter wird über an seine beiden äußeren Kontaktflächen angelötete Anschlussleitungen elektrisch in Reihe in den Versorgungsstromkreis des zu schützenden Gerätes geschaltet, so dass unterhalb der Ansprechtemperatur des Schalters der Versorgungsstrom des zu schützenden Gerätes durch den Schalter fließt.

Der bekannte Schalter weist ein tiefgezogenes Unterteil auf, in dem eine innen umlaufende Schulter vorgesehen ist, auf der ein Deckelteil aufliegt. Das Deckelteil wird durch eine hochgezogene und an ihrem oberen Abschnitt um ca. 60° nach innen abgebogene, umlaufende Wand des Unterteils fest auf dieser Schulter gehalten.

Da Deckelteil und Unterteil aus elektrisch leitfähigem Material gefertigt sind, ist zwischen ihnen noch eine um das Deckelteil herum verlaufende Isolierfolie vorgesehen, die sich innen in dem Schalter parallel zu dem Deckelteil erstreckt und seitlich nach oben hochgezogen ist, so dass sich ihr Randbereich bis auf die Oberseite des Deckelteils erstreckt. Der abgebogene obere Abschnitt der umlaufenden Wand des Unterteils liegt dabei auf dem Randbereich der Isolierfolie auf, wobei Wand und Randbereich der Isolierfolie unter einem Winkel von ca. 30° zu der Oberseite des Deckelteils von dieser wegweisend verlaufen. Die Stirnseite des oberen Abschnittes der umlaufenden Wand weist zu der Isolierfolie also einen Winkel von 90° auf.

Das temperaturabhängige Schaltwerk umfasst eine Feder-Schnappscheibe, die das bewegliche Kontaktteil trägt, sowie eine über das bewegliche Kontaktteil gestülpte Bimetallscheibe. Die Feder-Schnappscheibe drückt das bewegliche Kontaktteil gegen einen stationären Gegenkontakt innen an dem Deckelteil.

Mit ihrem Rand stützt sich die Feder-Schnappscheibe im Unterteil des Gehäuses ab, so dass der elektrische Strom von dem Unterteil durch die Feder-Schnappscheibe und das bewegliche Kontaktteil in den stationären Gegenkontakt und von da in das Deckelteil fließt.

Als erster Außenanschluss dient eine erste äußere Kontaktfläche, die mittig auf dem Deckelteil angeordnet ist. Als zweiter Außenanschluss dient eine auf dem umgebördelten Rand des Unterteils vorgesehene zweite äußere Kontaktfläche. Es ist aber auch möglich, den zweiten Außenanschluss nicht an dem Rand, sondern seitlich an dem stromführenden Gehäuse oder an der Unterseite des Unterteils anzuordnen.

Aus der DE 198 27 113 C2 ist es bekannt, an der Feder-Schnappscheibe eine so genannte Kontaktbrücke anzubringen, die von der Feder-Schnappscheibe gegen zwei an dem Deckelteil vorgesehene stationäre Gegenkontakte gedrückt wird. In diesem Fall ist auch die zweite äußere Kontaktfläche auf der Oberseite des Deckelteils angeordnet. Die beiden Gegenkontakte sind durch das Deckelteil hindurch mit den beiden äußeren Kontaktflächen verbunden. Der Strom fließt dann von einer äußeren Kontaktfläche über den zugeordneten Gegenkontakt durch die Kontaktbrücke in den anderen stationären Gegenkontakt und von dort zu der anderen äußeren Kontaktfläche, so dass die Feder-Schnappscheibe selbst nicht vom Betriebsstrom durchflossen wird.

Diese Konstruktion wird insbesondere dann gewählt, wenn sehr hohe Ströme geschaltet werden müssen, die nicht mehr problemlos über die Federscheibe selbst geleitet werden können.

In beiden Konstruktionsvarianten ist für die temperaturabhängige Schaltfunktion eine Bimetallscheibe vorgesehen, die unterhalb ihrer Sprungtemperatur kräftefrei in dem Schaltwerk einliegt, wobei sie geometrisch zwischen dem Kontaktteil bzw. der Kontaktbrücke und der Feder-Schnappscheibe angeordnet ist.

Im Rahmen der vorliegenden Erfindung wird unter einem Bimetallteil ein mehrlagiges aktives blechförmiges Bauteil aus zwei, drei oder vier untrennbar miteinander verbundenen Komponenten mit unterschiedlichem Ausdehnungskoeffizienten verstanden. Die Verbindung der einzelnen Lagen aus Metallen oder Metalllegierungen sind stoffschlüssig oder formschlüssig und werden beispielsweise durch Walzen erreicht.

Derartige Bimetallteile weisen in ihrer Tieftemperaturstellung eine erste und ihrer Hochtemperaturstellung eine zweite stabile geometrische Konformation auf, zwischen denen sie temperaturabhängig nach Art einer Hysterese umspringen. Bei Änderungen der Temperatur über ihre Ansprechtemperatur hinaus oder unter ihre Rücksprungtemperatur schnappen die Bimetallteile in die jeweils andere Konformation um. Die Bimetallteile werden daher oft als Schnappscheiben bezeichnet, wobei sie in der Draufsicht eine längliche, ovale oder kreisrunde Form aufweisen können.

Erhöht sich jetzt die Temperatur der Bimetallscheibe infolge einer Temperaturerhöhung bei dem zu schützenden Gerät über die Sprungtemperatur hinaus, so verändert die Bimetallscheibe ihre Konfiguration und arbeitet so gegen die Feder-Schnappscheibe, dass sie das bewegliche Kontaktteil von dem stationären Gegenkontakt bzw. das Stromübertragungsglied von den beiden stationären Gegenkontakten abhebt, so dass der Schalter öffnet und das zu schützende Gerät abgeschaltet wird und sich nicht weiter aufheizen kann.

Bei diesen Konstruktionen ist die Bimetallscheibe unterhalb ihrer Sprungtemperatur mechanisch kräftefrei gelagert, wobei die Bimetallscheibe auch nicht zur Führung des Stromes eingesetzt wird.

Dabei ist von Vorteil, dass die Bimetallscheiben eine lange mechanische Lebensdauer aufweisen, und dass sich der Schaltpunkt, also die Sprungtemperatur der Bimetallscheibe, auch nach vielen Schaltspielen nicht verändert.

Sofern geringere Anforderungen an die mechanische Zuverlässigkeit bzw. die Stabilität der Sprungtemperatur gestellt werden, kann die Bimetall-Schnappscheibe auch die Funktion der Feder-Schnappscheibe und ggf. sogar des Stromübertragungsgliedes mit übernehmen, so dass das Schaltwerk nur eine Bimetallscheibe umfasst, die dann das bewegliche Kontaktteil trägt oder anstelle des Stromübertragungsglieds zwei Kontaktflächen aufweist, so dass die Bimetallscheibe nicht nur für den Schließdruck des Schalters sorgt, sondern im geschlossenen Zustand des Schalters auch den Strom führt.

Darüber hinaus ist es bekannt, derartige Schalter mit einem Parallelwiderstand zu versehen, der parallel zu den Außenanschlüssen geschaltet ist. Dieser Parallelwiderstand übernimmt bei geöffnetem Schalter einen Teil des Betriebsstroms und hält den Schalter auf einer Temperatur oberhalb der Sprungtemperatur, so dass sich der Schalter nach dem Abkühlen nicht automatisch wieder schließt. Derartige Schalter nennt man selbsthaltend.

Weiter ist es bekannt, derartige Schalter mit einem Vorwiderstand auszustatten, der von dem durch den Schalter fließenden Betriebsstrom durchflossen wird. Auf diese Weise wird in dem Vorwiderstand eine ohmsche Wärme erzeugt, die proportional zum Quadrat des fließenden Stroms ist. Übersteigt die Stromstärke ein zulässiges Maß, so führt die Wärme des Vorwiderstandes dazu, dass das Schaltwerk geöffnet wird.

Auf diese Weise wird ein zu schützendes Gerät bereits dann von seinem Versorgungsstromkreis abgeschaltet, wenn ein zu hoher Stromfluss zu verzeichnen ist, der noch gar nicht zu einer übermäßigen Erhitzung des Gerätes geführt hat.

Statt einer in der Regel runden Bimetallscheibe kann auch eine einseitig eingespannte Bimetallfeder verwendet werden, die ein bewegliches Kontaktteil oder eine Kontaktbrücke trägt.

Es können aber auch temperaturabhängige Schalter eingesetzt werden, die als Stromübertragungsglied keinen Kontaktteller, sondern ein Federteil aufweisen, das die beiden Gegenkontakt trägt oder an dem die beiden Gegenkontakte ausgebildet sind. Das Federteil kann ein Bimetallteil, insbesondere eine Bimetall-Schnappscheibe sein, die nicht nur für die temperaturabhängige Schaltfunktion sorgt, sondern gleichzeitig auch noch für den Kontaktdruck sorgt und den Strom führt, wenn der Schalter geschlossen ist.

Alle diese verschiedenen Konstruktionsvarianten lassen sich mit dem erfindungsgemäßen Schalter realisieren, insbesondere kann die Bimetallscheibe die Funktion der Feder-Schnappscheibe mit übernehmen.

Aus der DE 195 17 310 A1 ist ein zu dem aus der eingangs erwähnten DE 196 23 570 A1 vergleichbar aufgebauter temperaturabhängiger Schalter bekannt, bei dem das Deckelteil jedoch aus einem Kaltleitermaterial gefertigt ist und ohne Zwischenlage einer Isolierfolie auf einer innen umlaufenden Schulter des Unterteils aufliegen kann, auf die sie durch den um ca. 90° radial nach innen abgebogenen oberen Abschnitt der umlaufenden Wand des Unterteils gedrückt wird.

Auf diese Weise ist der Kaltleiterdeckel elektrisch parallel zu den beiden Außenanschlüssen geschaltet, so dass er dem Schalter eine Selbsthaltefunktion verleiht.

Derartige Kaltleiter werden auch als PTC-Widerstände bezeichnet. Sie werden beispielsweise aus halbleitenden, polykristallinen Keramiken wie BaTiOs gefertigt.

Auch bei dem aus der oben erwähnten DE 198 27 113 C2 bekannten, temperaturabhängigen Schalter mit Kontaktbrücke ist das Deckelteil aus Kaltleitermaterial gefertigt, so dass er ebenfalls eine Selbsthaltefunktion aufweist. An dem Deckelteil sind hier zwei Nieten angeordnet, deren außenliegende Köpfe die beiden Außenanschlüsse bilden, und deren innenliegende Köpfe als stationäre Gegenkontakte mit der Kontaktbrücke zusammenwirken.

Die DE 10 2015 110 509 A1 beschreibt Weiterbildungen der aus der DE 196 23 570 A1 und dem DE 198 27 113 C2 bekannten Schalter, bei denen der das Deckelteil übergreifende obere Abschnitt der umlaufenden Wand des Unterteils als kontinuierlich gewölbter Rand ausbildet ist, der mit seiner Stirnseite auf die Schutzfolie drückt. Der obere Abschnitt der umlaufenden Wand wird dabei nicht radial nach innen abgebogen, sondern in sich umgebogen, so dass er einen kontinuierlich gewölbten Rand nach Art einer Wulst ausbildet, wobei er mit seiner Stirnseite in Anlage mit der Schutzfolie gelangt.

Auf der Oberseite liegt zusätzlich eine weitere Isolierfolie auf, die sich bis unter die erste Isolierfolie erstreckt, so dass sich durch die beiden Isolierfolien sozusagen eine doppelte Abdichtung ergibt.

Die DE 10 2015 110 509 A1 schlägt ferner vor, den bekannten Schalter als Surface Mounted Device (SMD) nach der Reel Technik (Gurt und Spule) zu konfektionieren und mit Pick und Place SMD-Bestückungsautomaten auf eine Leiterplatte aufzubringen und dort zu montieren und z.B. im Reflowverfahren zu kontaktieren. Sowohl der gewölbte Rand als auch die eine oder die beiden Kontaktflächen auf der Oberseite des Deckelteils sollen dabei als Kontaktfläche für die Surface Mounted Technology (SMT)-Verbindung eingesetzt werden.

Dazu wird der Schalter mit dem Deckelteil auf die Leiterplatte aufgelegt, so dass die Kontaktfläche oder die Kontaktflächen auf der Oberseite des Deckelteils und der gewölbte Rand zur SMT-Kontaktierung zur Verfügung stehen. Der Rand dient dabei der mechanischen Festlegung und der thermischen Anbindung des Schalters an die Leiterplatte sowie der elektrischen Kontaktierung, wenn nur eine Kontaktfläche auf der Oberseite des Deckelteils vorhanden ist.

Der Erfinder der vorliegenden Anmeldung hat nun erkannt, dass eine SMD-Montage mit der in der DE 10 2015 110 509 A1 vorgeschlagenen Konstruktion erhebliche Probleme in der Massenproduktion mit sich bringt. Der gewölbte Rand steht bei vielen nach der DE 10 2015 110 509 A1 gefertigten Schaltern merklich über die Kontaktfläche auf der Oberseite über, so dass eine sichere Kontaktierung an der Kontaktfläche nicht gewährleistet ist. Die DE 10 2015 110 509 A1 schlägt vor, den Höhenunterschied durch das Lot im ReflowVerfahren auszugleichen, was sich aber in der Praxis nicht bewährt hat.

Hinzu kommt, dass die Isolierfolie auf dem Deckel relativ dick ist und daher das Kontaktieren der Anschlussflächen behindert, teilweise sogar verhindert. Die sich um den Deckel herum erstreckende Isolierfolie ist zudem so steif, dass sie trotz des umgebogenen Randes nach oben vorsteht und das Kontaktieren des Randes behindert, teilweise sogar verhindert.

Vor diesem Hintergrund liegt der vorliegenden Erfindung die Aufgabe zugrunde, bei dem bekannten Schalter auf konstruktiv einfache und preiswerte Weise die oben erwähnten Probleme bei der SMD-Montage zu verringern.

Diese Aufgabe wird bei der eingangs genannten Vorrichtung erfindungsgemäß dadurch gelöst, dass der obere Rand der Wand der Montagekappe in einer Ebene mit der ersten äußeren Kontaktfläche liegt.

Erfindungsgemäß wird also nicht der Schalter verändert, sondern es wird eine Montagekappe geschaffen, die für jede Art von temperaturabhängigem Schalter ausgelegt werden kann und sowohl der elektrischen Anschluss als auch der mechanischen Fixierung dienen kann.

Beliebige Schalter-Bauformen können so für eine SMD-Montage verwendet werden, weil der Rand der Montagekappe als Anschluss und/oder zum Halten und Abdichten verwendet werden kann. Der Rand umgibt dabei den Schalter so, dass er durch Ausgießen auch hermetisch abgedichtet werden kann, was derart aufgenommene Schalter für besondere Schutzklassen einsetzbar macht.

Der Überstand des Randes kann dabei sehr leicht an die Höhe der Anschlussflächen angepasst werden, wenn z.B. der Deckel von Nieten durchsetzt ist, deren äußere Köpfe die Kontaktflächen bilden. Auch das vollautomatische Verlöten ist problemlos möglich.

Diese Anpassung ist einfacher zu erzielen, als es bei dem bekannten Schalter mit dem umgebogenen Rand des Unterteils der Fall ist. Die Montagekappe wird nämlich als gesondertes Teil gefertigt, das lediglich der Positionierung des Schalters dient, so dass hier die Maße des Randes im Vordergrund stehen können, während bei einem Schalter immer die Schaltsicherheit im Vordergrund steht, die durch die Anordnung, Ausrichtung und Funktion des Schaltwerkes bedingt ist.

Der Erfinder der vorliegenden Anmeldung hat erkannt, dass die Aufteilung der Anforderungen "Schaltsicherheit" und "Montagesicherheit" einerseits auf den temperaturabhängigen Schalter und andererseits auf die Montagekappe die Probleme bei dem bekannten Schalter beseitigt.

Zwar ist ein zusätzliches Bauteil in der Regel unter Kosten- und Montagegesichtspunkten eher von Nachteil, wieder erwarten werden diese Nachteile jedoch dadurch mehr als ausgeglichen, dass mit der neuen Montagekappe verschiedene, existierende Schalter-Bauformen sicher für die SMD-Montage eingesetzt werden können.

Es müssen also keine neuen Schalter konzipiert werden, sondern alle die Schalter, deren Bauform und Funktion sich bewährt haben, können jetzt für die SMD-Montage eingesetzt werden.

Vor diesem Hintergrund betrifft die vorliegende Erfindung auch eine elektronische Schaltung mit zumindest einem in einer metallenen Montagekappe angeordneten und mit dieser auf einer Leiterplatte montierten temperaturabhängigen Schalter, wobei der Rand der Montagekappe auf der Leiterplatte aufliegt.

Erfindungsgemäß ist es vorgesehen, dass der obere Rand der Wand der Montagekappe in einer Ebene mit der ersten äußeren Kontaktfläche liegt.

Dies hat den Vorteil, dass die Montagekappe direkt für die Ausrichtung des Randes und der ersten äußeren Kontaktfläche zueinander sorgt, die für die SMD-Montage notwendig ist. Da der obere Rand der Montagekappe mit der ersten äußeren Kontaktfläche in einer Ebene liegt, kann der Schalter samt Montagekappe über Kopf auf einer Leiterplatte angeordnet werden und der Rand sowie die erste äußere Kontaktfläche mit entsprechenden Leiterbahnen verbunden (z.B. verlötet) werden, ohne dass hierzu zwingend ein Höhenausgleich zwischen dem Rand der Montagekappe und der ersten äußeren Kontaktfläche notwendig ist.

Dabei ist es bevorzugt, wenn das Gehäuse ein Deckelteil, an dem die Oberseite ausgebildet ist, und ein Unterteil aufweist, an dem die Außenseite des Gehäuses ausgebildet ist, wobei das Deckelteil an dem Unterteil gehalten ist, wobei vorzugsweise die Innenseite der Wand der Montagekappe vollflächig an der Außenseite des Unterteils anliegt.

Hier ist von Vorteil, dass Standardschalter verwendet werden, die zumeist rund oder kreisförmig sind, die gut und einfach in eine entsprechenden Montagekappe eingebracht werden kann und dort sicher gehalten wird.

Weiter ist es bevorzugt, wenn die zweite äußere Kontaktfläche durch die Außenseite des Unterteils gebildet ist.

Hier ist von Vorteil, dass das Unterteil aus Metall gefertigt wird, was einen guten elektrischen und thermischen Kontakt zu der ebenfalls aus Metall gefertigten Montagekappe ermöglicht, deren Rand dann sowohl zum mechanischen Halten als auch für den elektrischen Anschluss des Schalters verwendet wird.

Andererseits ist es bevorzugt, wenn die zweite äußere Kontaktfläche auf der Oberseite des Deckelteils angeordnet ist.

Hier ist von Vorteil, dass sich beide Außenanaschlüsse auf dem Deckel befinden, so dass auch Standardschalter für hohe Ströme mit der neuen Montagekappe verwendet werden können. Der Rand der montagekappe dient hier nur zum mechanischen Halten, das Unterteil muss nicht zwingend aus Metall sein, und der Deckel kann auch aus PCT-Material bestehen.

Andererseits ist es bevorzugt, wenn aus dem Gehäuse seitlich zumindest ein Anschlusskontakt vorsteht, der mit der ersten äußeren Kontaktfläche elektrisch leitend verbunden ist, wobei vorzugsweise aus dem Gehäuse seitlich zwei Anschlusskontakte vorstehen, die mit der ersten bzw. der zweiten äußeren Kontaktfläche elektrisch leitend verbunden sind, wobei die erste und die zweite äußere Kontaktfläche auf der Oberseite des Deckelteils angeordnet sind.

Hier ist von Vorteil, dass in die Montagekappe Standardschalter mit Einschubgehäuse eingesetzt werden können, wie sie beispielsweise aus der DE 198 16 807 A1 bekannt sind. Die seitlichen Anschlusskontakte müssen dazu ggf. mit Litzen versehen werden, die dann zu Kontaktflächen auf der Oberseite geführt werden.

Weiter ist es bevorzugt, wenn das Gehäuse klemmend in der Montagekappe gehalten ist.

Hier ist von Vorteil, dass die Montagekappe als Ring ohne Boden ausgebildet sein kann. Der Schalter ist dann kreisrund und wird in den ggf. zuvor leicht erhitzten Ring eingedrückt, was einen schnellen Zusammenbau ermöglicht.

Andererseits ist es bevorzugt, wenn die Montagekappe einen Boden aufweist, auf dem das Gehäuse mit seiner Unterseite aufliegt, wobei der Boden vorzugsweise eine zentrische Öffnung aufweist, die vorzugsweise mindestens 50% der Unterseite freigibt.

Hier ist zum einen von Vorteil, dass der Schalter in Relation zum Rand der Montagekappe einfach zu positionieren ist, er muss lediglich bis zum Boden in sie hineingedrückt werden. Zum anderen erlaubt die Öffnung im Boden der Montagekappe eine gute thermische Ankopplung an das zu schützende Gerät.

Allgemein ist es bevorzugt, wenn der sich auf der Oberseite des Gehäuses zwischen der Wand der Montagekappe und der Oberseite des Schalters bildende Raum mit Dichtmittel wie bspw. Lack oder Harz verfüllt ist.

Hier ist von Vorteil, dass der Schalter hermetisch abgedichtet und somit für Anwendungen in bis zu sehr hohen Sicherheitsklassen verwendet werden kann. Ein weiterer Vorteil besteht darin, dass durch das Dichtmittel eine feste Verbindung zwischen dem Schalter und der Montagekappe hergestellt wird, so dass der mit der Montagekappe versehene Schalter als Halbfabrikat gelagert werden kann, wobei der Schalter bereits hermetisch dicht ist.

Auf der Oberseite des Schalters befinden sich eine oder zwei Kontaktflächen für den Außenanschluss, die in einer Ausgestaltung von dem Dichtmittel frei gelassen werden, so dass die Distanzstücke erst bei einer späteren Verwendung montiert, insbesondere angelötet oder angeschweißt werden können. In einer anderen Ausgestaltung werden die Distanzstücke auf der oder den Anschlussflächen montiert, bevor der Raum zwischen der Wand der Montagekappe und der Oberseite des Schalters mit dem Dichtmittel verfüllt wird.

Weiter ist es bevorzugt, wenn auf der Oberseite des Gehäuses zumindest eine erste Anschlussfläche ausgebildet ist, mit der ein erstes Distanzstück verbunden ist, an dem die erste äußere Kontaktfläche ausgebildet ist, wobei vorzugsweise auf der Oberseite des Gehäuses eine zweite Anschlussfläche ausgebildet ist, mit der ein zweites Distanzstück verbunden ist, an dem die zweite äußere Kontaktfläche ausgebildet ist, und weiter vorzugsweise das erste und/oder zweite Distanzstück als Schweißwinkel ausgebildet ist.

Hier ist von Vorteil, dass der Höhenunterschied zwischen dem Rand der Montagekappe und jeder der Kontaktflächen einfach ausgeglichen werden kann, wobei die Schweißwinkel einen flexiblen Ausgleich des Höhenunterschiedes und eine einfache Möglichkeit bieten, die Lage der Kontaktflächen auf der Oberseite frei zu wählen.

In einer weiteren Ausgestaltung ist es vorgesehen, dass die Wand der Montagekappe unterbrochen ist.

Die hat den Vorteil, dass sich hierdurch der Übergangswiderstand, der durch die Montagekappe erzeugt wird, reduzieren lässt. Dennoch ist garantiert, dass das Gehäuse des Schalters ausreichend stabil in der Montagekappe gehalten wird.

Beispielsweise kann die Wand der Montagekappe durch einzelne Freiräume oder Aussparungen unterbrochen sein. Die Montagekappe hat in dieser Ausgestaltung also keine vollflächige Wand, die sich über den gesamten Umfang der Montagekappe erstreckt. Einzelne Umfangsteile der Wand der Montagekappe können freigelassen sein.

Beispielsweise ist es in einer Ausgestaltung bevorzugt, dass die Montagekappe mehrere, voneinander in Umfangsrichtung beabstandete Stege aufweist, wobei eine dem Gehäuse zugewandte Innenseite der Stege die Innenseite der unterbrochenen Wand der Montagekappe bildet.

Derartige Stege haben den Vorteil, dass diese trotz einer relativ geringen Größe für einen stabilen Sitz des Schalter-Gehäuses innerhalb der Montagekappe sorgen können. Die jeweilige Innenseite der Stege liegt an der Außenseite des Gehäuses vorzugsweise bündig an und sorgt für eine Klemmwirkung, durch die das Schalter-Gehäuse in der Montagekappe gehalten wird.

Beispielsweise können zwei, drei, vier oder mehr als vier dieser Stege vorgesehen sein, die in Umfangsrichtung voneinander beabstandet sind und einen Teil der Montagekappe bilden.

Vorzugsweise sind die Stege im Querschnitt jeweils im Wesentlichen L-förmig.

Dies hat den Vorteil, dass die Stege als eine Art Krallen wirken, die das Schalter-Gehäuse festklemmen bzw. festhalten. Um dies gewährleisten zu können, sind die L-förmigen Stege bzw. Krallen vorzugsweise federnd ausgestaltet. Dies hat den Vorteil, dass die Stege bzw. Krallen beim Einschieben des Schalter-Gehäuses in die Aufnahmekappe etwas nachgeben und dabei beispielsweise eine Ausweichbewegung in radialer Richtung vornehmen können.

Dabei ist es ferner bevorzugt, dass die Stege jeweils einen ersten Stegabschnitt, der an der Außenseite des Gehäuses anliegt, und einen zweiten Stegabschnitt, der gegenüber dem ersten Stegabschnitt abgewinkelt ist und auf dem das Gehäuse mit seiner Unterseite aufliegt, aufweisen.

Die ersten Stegabschnitte liegen also umfangsseitig an der Außenseite des Schalter-Gehäuses an und die zweiten Stegabschnitte stützen das Schaltergehäuse von seiner Unterseite her. Die Stege dienen somit nicht nur als einzelne Krallen, sondern bilden gemeinsam eine Art Korb, in dem der Schalter bzw. das Schalter-Gehäuse sicher aufgenommen ist. Da dieser Korb das Schalter-Gehäuse nicht vollflächig umgibt, sondern das Schalter-Gehäuse nur entlang der einzelnen Stege kontaktiert wird, lässt sich der Übergang, wie oben bereits erwähnt, deutlich reduzieren.

Weiterhin ist es in dieser Ausgestaltung bevorzugt, dass die ersten Stegabschnitte der Stege sich entlang zueinander paralleler Achsen erstrecken und die zweiten Stegabschnitte in einer gemeinsamen Ebene liegen, die quer zu den Achsen der ersten Stegabschnitte ausgerichtet ist.

Unter "quer" wird vorliegend jede Art der nicht-parallelen Ausrichtung verstanden. "Quer" bedeutet also nicht-parallel, demnach jeder Winkel ungleich 0°.Vorzugsweise ist die Ebene, in der die zweiten Stegabschnitte liegen, orthogonal zu den Achsen der ersten Stegabschnitte ausgerichtet. Die zweiten Stegabschnitte bilden somit eine Art Boden, auf dem das Schalter-Gehäuse mit seiner Unterseite stabil aufliegen kann. Die dazu orthogonal verlaufenden ersten Stegabschnitte klemmen das Schalter-Gehäuse von seiner Außenseite her und üben vorzugsweise jeweils einen Druck in radialer Richtung nach innen auf das Schalter-Gehäuse aus.

Des Weiteren ist es in dieser Ausgestaltung bevorzugt, dass zumindest einer der Stege mit dem Gehäuse stoffschlüssig verbunden ist.

Dies hat den Vorteil, dass die Verbindung zwischen der Montagekappe und dem Schalter-Gehäuse noch stabiler ist. Ein Verrutschen des Schalter-Gehäuses innerhalb der Montagekappe ist dadurch nahezu ausgeschlossen.

Vorzugsweise ist nicht nur einer der Stege, sondern jeder der Stege mit dem Gehäuse stoffschlüssig verbunden. Beispielsweise können die Stege mit dem Gehäuse verschweißt, verlötet oder verklebt sein. Besonders bevorzugt sind die Stege jeweils mit ihrem zweiten Stegabschnitt mit dem Schalter-Gehäuse verschweißt, verlötet oder verklebt.

In der Ausgestaltung der Montagekappe mit einer unterbrochenen Wand und einzelnen Stegen ist es ferner bevorzugt, dass die Stege über einen im Wesentlichen ringförmigen Bund miteinander verbunden sind, der an einer von den Stegen abgewandten Oberseite eine im Wesentlichen kreisringförmige Auflagefläche aufweist, die den oberen Rand der Montagekappe bildet.

Die kreisringförmige Auflagefläche, die den oberen Rand der Montagekappe bildet, liegt in montiertem Zustand des Schalters vorzugsweise in einer Ebene mit der ersten äußeren Kontaktfläche. Somit ist für die Ausrichtung des Randes der Montagekappe und der ersten äußeren Kontaktfläche zueinander gesorgt, was für die SMD-Montage überaus wichtig ist. Da der obere Rand der Montagekappe bzw. die kreisringförmige Auflagefläche mit der ersten äußeren Kontaktfläche des Schalters in einer Ebene liegt, kann der Schalter samt Montagekappe über Kopf auf einer Leiterplatte angeordnet werden und der Rand sowie die erste äußere Kontaktfläche mit entsprechenden Leiterbahnen verbunden (z.B. verlötet) werden, ohne dass es hierzu zwingend eines Höhenausgleichs zwischen dem Rand der Montagekappe und der ersten äußeren Kontaktfläche bedarf.

Die genannte Ausrichtung des Randes der Montagekappe mit der ersten Kontaktfläche des Schalters erfolgt während der Herstellung vorzugsweise in einem Werkzeug, das die Montage des Schalters innerhalb der Montagekappe durchführt. Die Montagekappe wird dabei mit der kreisringförmigen Auflagefläche auf eine Planfläche des Werkzeugs aufgelegt und der Schalter mit dem Deckelteil zuerst in die Montagekappe derart eingebracht, dass die an dem Deckelteil angeordnete erste äußere Kontaktfläche ebenfalls auf der Planfläche des Werkzeugs aufliegt. Die erste äußere Kontaktfläche und der obere Rand der Montagekappe befinden sich somit zwangsläufig auf einer Höhe. Dann werden die genannten zweiten Stegabschnitte gegenüber den ersten Stegabschnitten abgewinkelt, was beispielsweise durch ein Umbiegen oder Umbördeln dieser geschieht. Die zweiten Stegabschnitte werden derart umgebogen bzw. umgebördelt, dass diese an der Unterseite des Unterteils des Schaltergehäuses anliegen. Danach können diese, wie bereits erwähnt, mit dem Schalter-Gehäuse zusätzlich auch noch stoffschlüssig verbunden werden.

Letztendlich ergibt sich eine stabile Verbindung zwischen Montagekappe und Schalter-Gehäuse, bei der gleichzeitig dafür gesorgt ist, dass die an dem Deckelteil angeordnete erste äußere Kontaktfläche des Schalters in einer gemeinsamen Ebene mit dem oberen Rand der Montagekappe liegt.

Der wesentliche Vorteil einer solchen Montage besteht darin, dass diese sehr einfach und damit preiswert realisierbar ist. Da zudem keine weitere Höhenanpassung erforderlich ist, lässt sich der Schalter samt Montagekappe sehr einfach und damit ebenfalls kostengünstig auf einer Leiterplatte per SMD-Montage anbringen.

Allgemein ist es bevorzugt, wenn das Schaltwerk ein bewegliches Kontaktteil trägt, das mit einem stationären Gegenkontakt zusammenwirkt, der an einer Innenseite des Deckelteils angeordnet ist und mit der an der Oberseite angeordneten ersten äußeren Kontaktfläche zusammenwirkt, bzw. das Schaltwerk ein Stromübertragungsglied trägt, das mit zwei stationären Gegenkontakten zusammenwirkt, die an einer Innenseite des Deckelteil angeordnet sind und von denen jeweils einer mit einer von zwei an der Oberseite angeordneten äußeren Kontaktflächen zusammenwirkt, wobei vorzugsweise das Schaltwerk ein Bimetallteil und eine Feder-Schnappscheibe aufweist.

Dies sind die gängigen Bauformen von temperaturabhängigen Schaltern, die mit der Montagekappe verwendet werden können.

Bei der elektronischen Schaltung ist es bevorzugt, wenn die erste äußere Kontaktfläche auf eine an der Leiterplatte vorgesehene erste Lötfläche zu weist und mit dieser verlötet ist, und wenn der Rand der Montagekappe auf eine an der Leiterplatte vorgesehene zweite Lötfläche zu weist und mit dieser verlötet ist. wobei vorzugsweise die zweite Lötfläche eine ringförmige Lötfläche ist, und der Rand längs seines gesamten Umfanges durchgehend mit der zweiten Lötfläche verlötet ist.

Hier ist von Vorteil, dass der Rand der Montagekappe nicht nur der elektrischen Kontaktierung dient, sondern gleichzeitig auch als Barriere gegen den Eintrag von Verunreinigungen dient, weil nämlich die Oberseite des Schalters durch die als Barriere wirkende Verlötung des Randes effektiv vor dem Eintrag von partikelförmigen oder flüssigen Verunreinigungen geschützt ist.

Dabei ist es weiter bevorzugt, wenn die zweite äußere Kontaktfläche an dem Rand angeordnet ist, wobei alternativ die zweite äußere Kontaktfläche auch an der Oberseite des Deckelteils angeordnet sein kann und mit einer an der Leiterplatte vorgesehenen dritten Lötfläche verlötet ist.

Hier ist von Vorteil, dass der Rand sowohl zur mechanischen Fixierung als auch zur Bildung einer Barriere gegen Verschmutzung dienen kann, wobei er gleichzeitig auch als zweite Kontaktfläche dienen kann.

Dabei ist es noch bevorzugt, wenn in der Leiterplatte eine Entlüftungsbohrung vorgesehen ist, die in einem Raum mündet, der zwischen der Leiterplatte und dem Rand der Montagekappe ausgebildet ist.

Hier ist von Vorteil, dass sich in diesem Raum, der nach dem Verlöten des Randes gegenüber der Umwelt vollständig abgeschlossen ist, kein Überdruck bildet, der einer sicheren mechanischen und elektrischen Verbindung der Kontaktflächen mit den Lötflächen auf der Leiterplatte entgegenwirken würde.

In einer besonders bevorzugten Ausgestaltung betrifft die vorliegende Erfindung einen temperaturabhängigen Schalter mit einem Gehäuse, das ein Deckelteil mit einer Oberseite und ein Unterteil mit einer umlaufenden Außenseite umfasst, mit zumindest einer auf der Oberseite des Deckelteils angeordneten ersten äußeren Kontaktfläche, zumindest einer außen an dem Gehäuse angeordneten zweiten äußeren Kontaktfläche, wobei das Deckelteil an dem Unterteil gehalten ist, und mit einem in dem Gehäuse angeordneten temperaturabhängigen Schaltwerk, das in Abhängigkeit von seiner Temperatur eine elektrisch leitende Verbindung zwischen der ersten und der zweiten äußeren Kontaktfläche herstellt oder öffnet, wobei das Gehäuse in einer metallenen Montagekappe mit einer umlaufenden Wand aufgenommen ist, deren oberer Rand die Oberseite des Deckelteils überragt und deren Innenseite an der Außenseite des Unterteils anliegt, wobei der obere Rand in einer Ebene mit der ersten äußeren Kontaktfläche liegt.

Weitere Merkmale und Vorteile ergeben sich aus der Beschreibung und der beigefügten Zeichnung.

Es versteht sich, dass die vorstehend genannten und die nachstehend noch zu erläuternden Merkmale nicht nur in jeweils angegebenen Kombinationen, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine schematische Schnittdarstellung in Seitenansicht eines temperaturabhängigen Schalters aus dem Stand der Technik;
- Fig. 2: in einer schematischen, teilweise geschnitten Darstellung in Seitenansicht den in einer Montagekappe angeordneten und mit einem Schweißwinkel versehenen Schalter aus Fig. 1, und unten eine Draufsicht auf eine Leiterplatte, auf die der Schalter aufgelötet wird;
- Fig. 3: in einer Darstellung wie Fig. 2 eine Montagekappe mit einem darin aufgenommenen temperaturabhängigen Schalter, bei dem die beiden Außenanschlüssen auf der Oberseite Schalter angeordnet sind;
- Fig. 4: in einer schematischen, teilweise geschnitten Teil-Darstellung in Seitenansicht den auf einer Leiterplatte montierten Schalter aus Fig. 3;
- Fig. 5: in einer Darstellung wie Fig. 2 eine Montagekappe mit einem darin aufgenommenen temperaturabhängigen Schalter, bei dem die beiden Außenanschlüssen seitlich aus Gehäuse herausgeführt sind;
- Fig. 6: in einer schematischen Darstellung eine Draufsicht auf den Schalter aus Fig. 5;
- Fig. 7: einen Schalter 10 wie in Fig. 1, in einer Montagekappe angeordnet, oben in geschnittener Seitenansicht und unten in Explosionsdarstellung;
- Fig. 8: in einer schematischen Darstellung eine perspektivische Ansicht eines weiteren Ausführungsbeispiels der Montagekappe;
- Fig. 9: in einer schematischen Darstellung eine Draufsicht der in Fig. 9 gezeigten Montagekappe; und
- Fig. 10: in einer schematischen Darstellung eine Schnittansicht der in Fig. 8 und 9 gezeigten Montagekappe mit darin montiertem Schalter.

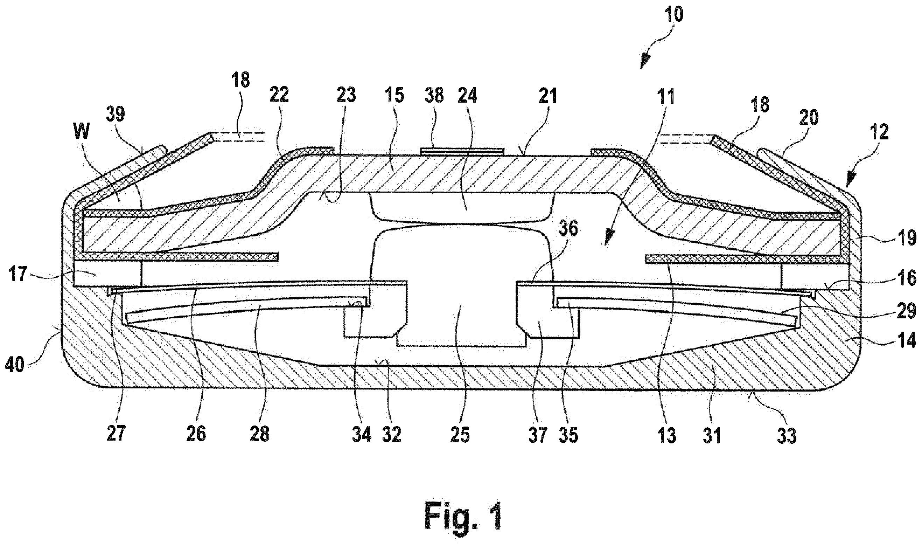

In Fig. 1 ist schematisch, nicht maßstabsgetreu und im seitlichen Schnitt ein in der Draufsicht kreisförmiger temperaturabhängiger Schalter 10 gezeigt, wie er aus dem Stand der Technik bekannt ist und erfindungsgemäß eingesetzt wird.

Der bekannte Schalter 10 weist ein temperaturabhängiges Schaltwerk 11 auf, das in einem Gehäuse 12 angeordnet ist, in dem eine Isolierfolie 13 angeordnet ist, die zwischen einem topfartigen Unterteil 14 und einem Deckelteil 15 verläuft, das das Unterteil 14 verschließt.

In dem Unterteil 14 ist eine umlaufende, gestufte Schulter 16 vorgesehen, auf der ein Distanzring 17 angeordnet ist, auf dem das Deckelteil 15 unter Zwischenlager der Isolierfolie 13 aufliegt, deren Randbereich 18 sich bis auf die Oberseite des Deckelteils 15 erstreckt.

Das Unterteil 14 weist eine umlaufende Wand 19 auf, deren oberer Abschnitt 20 das Deckelteil 15 übergreift. Der obere Abschnitt 20 ist nach radial nach innen so abgebogen, dass er das Deckelteil 15 auf den Distanzring 17 und diesen auf die umlaufenden Schulter 16 drückt.

Unterteil 14 und Deckelteil 15 sind in dem gezeigten Ausführungsbeispiel aus elektrisch leitendem Material gefertigt, weshalb die um das Deckelteil 15 herum verlaufende Isolierfolie 13 vorgesehen ist, die innen in dem Gehäuse 12 parallel zu dem Deckelteil 15 verläuft, seitlich zwischen der Wand 19 und dem Deckelteil 15 nach oben geführt ist und mit ihrem Randbereich 18 nach oben weist.

Der obere Abschnitt 20 der Wand 19 liegt dabei flach auf dem Randbereich 18 der Isolierfolie 13 auf, und drückt diesen in Richtung Oberseite 21 des Deckelteils 14. Die an ihrem Randbereich 18 dadurch radial nach innen geklappte, steife Isolierfolie 13 wird dabei in ihrem Randbereich 18 wellig und bildet Falten aus, wodurch sie einen Gegendruck auf den oberen Abschnitt 20 ausübt, so dass Randbereich 18 und oberer Abschnitt 18 zu der Oberseite 21 unter einem Winkel W verlaufen, der ca. 30° beträgt.

Durch diese Konstruktion steht der Randbereich 18 nach oben über den oberen Abschnitt 20 über.

An der Oberseite 21 des Deckelteils 15, die gleichzeitig die Oberseite des Gehäuses 12 ist, ist eine weitere isolierende Abdeckung 22 vorgesehen, die sich radial nach außen bis zu dem Randbereich 18 der Isolierfolie 13 erstreckt.

An einer Innenseite 23 des Deckelteils 15 ist ein stationärer Gegenkontakt 24 angeordnet, mit dem ein von dem Schaltwerk 11 getragenes, bewegliches Kontaktteil 25 zusammenarbeitet.

Das Schaltwerk 11 umfasst eine Feder-Schnappscheibe 26, die mit ihrem Rand 27 dauerhaft zwischen dem Distanzring 17 und der Schulter 16 eingeklemmt ist, so dass sie dort eine permanente elektrisch leitende Verbindung herstellt.

Unterhalb der Feder-Schnappscheibe 26, also an ihrer von dem stationären Gegenkontakt 24 wegweisenden Seite, ist eine Bimetall-Schnappscheibe 28 vorgesehen, die zwei geometrische Temperaturstellungen aufweist, die in Fig. 1 gezeigte Tieftemperaturstellung und eine nicht gezeigte Hochtemperaturstellung.

Die Bimetall-Schnappscheibe 28 liegt mit ihrem Rand 29 frei oberhalb einer keilförmigen, umlaufenden Schulter 31, die an einem inneren Boden 32 des Unterteils 14 ausgebildet ist.

Das Unterteil 14 weist eine Unterseite 33 auf, mit der ein thermischer Kontakt zu einem zu schützenden Gerät hergestellt wird.

Die Bimetall-Schnappscheibe 28 stützt sich auf einer umlaufenden Schulter 34 des Kontaktteiles 25 mit ihrem Zentrum 35 ab.

Die Feder-Schnappscheibe 26 ist mit einem inneren Bereich 36 in ihrem Zentrum dauerhaft mit dem beweglichen Kontaktteil 25 verbunden, wozu auf dessen Zapfen, der durch die beiden Schnappscheiben 26 und 28 hindurch ragt, ein Ring 37 aufgepresst ist, an dem auch die Schulter 34 ausgebildet ist.

Der elektrisch leitend mit der Oberseite 21 verbundene stationäre Gegenkontakt 24 wirkt mit dem beweglichen Kontaktteil 25 und über dieses mit dem inneren Bereich 36 der Feder-Schnappscheibe 26 zusammen, die mechanisch und elektrisch dauerhaft mit der Schulter 16 und über diese mit dem Unterteil 14 verbunden ist.

Die Oberseite 21 dient als erste äußere Kontaktfläche 38, was durch eine schwarze Fläche angedeutet ist. Die Unterseite 33 des Unterteils 14 dient bei dem bekannten Schalter als weitere Kontaktfläche, wobei es auch bekannt ist, als zweite äußere Kontaktfläche 39 den obere Abschnitt 20 der Wand 19 oder die Außenseite 40 des Unterteils 14 zu verwenden, die gleichzeitig die Außenseite des Gehäuses 12 ist.

In der in Fig. 1 gezeigten, geschlossenen Schaltstellung des Schalters 10 wird das bewegliche Kontaktteil 25 durch die Feder-Schnappscheibe 26 gegen den stationären Gegenkontakt 24 gedrückt. Weil die elektrisch leitende Feder-Schnappscheibe 26 mit ihrem Rand 27 in Verbindung mit dem Unterteil 14 steht, ist eine elektrisch leitende Verbindung zwischen den beiden äußeren Kontaktflächen 38, 39 hergestellt.

Wenn sich jetzt die Temperatur im Inneren des Schalters 10 über die Ansprechtemperatur der Bimetall-Schnappscheibe 28 hinaus erhöht, so klappt diese von der in Fig. 1 gezeigten konvexen Konfiguration in eine konkave Konfiguration um, in der sich ihr Rand 29 in Fig. 1 nach oben bewegt, so dass er von unten in Anlage mit dem Rand 27 der Feder-Schnappscheibe 26 gelangt.

Dabei drückt die Bimetall-Schnappscheibe 28 mit ihrem Zentrum 35 auf die Schulter 34 und hebt somit das bewegliche Kontaktteil 25 von dem stationären Gegenkontakt 24 ab.

Die Feder-Schnappscheibe 26 kann eine bistabile Federscheibe sein, die auch in der geöffneten Stellung des Schalters geometrisch stabil ist, so dass das bewegliche Kontaktteil 25 auch dann nicht wieder in Anlage mit dem stationären Gegenkontakt 24 gelangt, wenn der Rand 29 der Bimetall-Schnappscheibe 28 nicht mehr gegen den Rand 27 der Feder-Schnappscheibe 26 drückt.

Wenn sich jetzt die Temperatur im Inneren des Schalters 10 wieder erniedrigt, so bewegt sich der Rand 29 der Bimetall-Schnappscheibe 26 nach unten und gelangt in Anlage mit der keilförmigen Schulter 31. Mit ihrem Zentrum 35 drückt die Bimetall-Schnappscheibe 26 dann von unten gegen die Feder-Schnappscheibe 26 und drückt diese wieder in ihre andere geometrisch stabile Position, in der sie gemäß Fig. 1 das bewegliche Kontaktteil 25 gegen den stationären Gegenkontakt 24 drückt.

Im vorliegenden Ausführungsbeispiel weist das Schaltwerk 11 zusätzlich zu der Bimetall-Schnappscheibe 28 die stromführende Feder-Schnappscheibe 26 auf, wobei in dem Schaltwerk 11 auch lediglich die Bimetall-Schnappscheibe 28 vorgesehen sein kann, die dann mit ihrem Rand 29 unter dem umlaufenden Ring 17 eingeklemmt wäre und den Strom führen würde.

Es ist auch möglich, die Bimetall-Schnappscheibe 28 oberhalb der Feder-Schnappscheibe 26 anzuordnen.

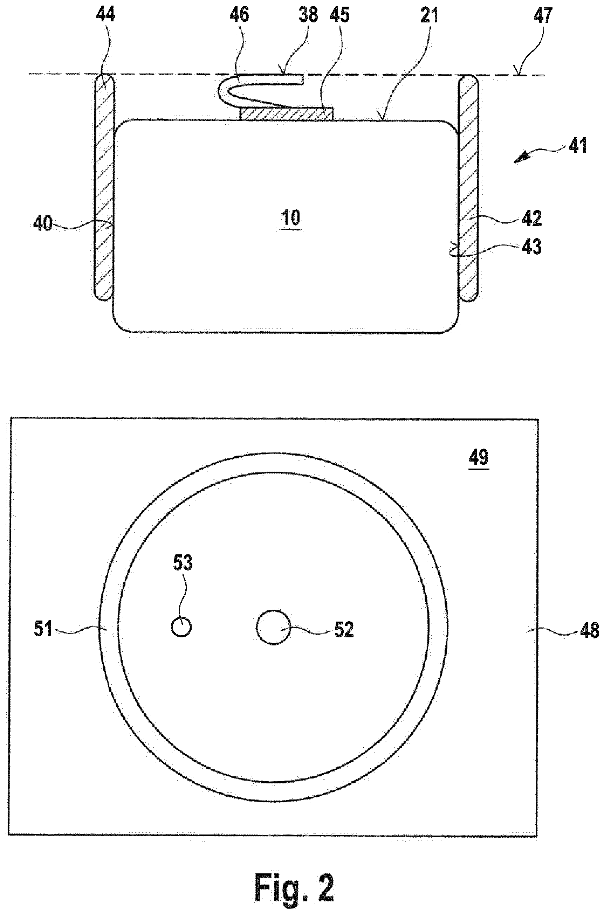

In Fig. 2 ist die erfindungsgemäße Verwendung des Schalters 10 aus Fig. 1 gezeigt, wobei der Schalter 10 selbst nur schematisch dargestellt ist. Der Schalter 10 ist in einer geschnitten dargestellten metallenen Montagekappe 41 angeordnet, deren ringförmige Wand 42 mit ihrer Innenseite 43 vollflächig an der Außenseite 40 des Schalters 10 anliegt, und mit ihrem oberen Rand 44 die Oberseite 21 des Schalters 10 überragt.

Der enge mechanische Kontakt zwischen der ringförmigen Montagekappe 41 und der Außenseite 40 wird dadurch erreicht, dass die Montagekappe 41 erhitzt wird, bevor der Schalter 10 eingeschoben wird. Nach dem Abkühlen wird der Schalter 10 dann fest in der Montagekappe 41 gehalten.

Als erster Außenanschluss des Schalters 10 dient hier die Oberseite 21 des Deckelteils 15, auf der sich eine Anschlussfläche 45 befindet, an die ein Schweißwinkel 46 angeschweißt, der an seinem äußeren Ende die erste äußere Kontaktfläche 38 trägt, wobei das Ende so umgebogen ist, dass es mit der Kontaktfläche 38 in einer bei 47 angedeuteten Ebene mit dem Rand 44 liegt. Das Ende des Schweißwinkels 46 kann dabei auch nachträglich noch nachgebogen werden, bis die Kontaktfläche 38 in der Ebene 47 liegt.

Die zweite äußere Kontaktfläche 39 wird durch die Außenseite 40 gebildet, die durch den engen mechanischen Kontakt zu der Innenseite 43 der Wand 42 und über diese auch elektrisch mit dem Rand 44 in elektrisch leitender Verbindung steht.

Der in der ringförmigen Montagekappe 41 gehaltene Schalter 10 wird über Kopf auf eine Leiterplatte 48 aufgelötet, wobei der Rand 44 und die Kontaktfläche 38 mit entsprechenden Lötflächen auf der in Fig. 2 unten gezeigten Leiterplatte 48 verlötet werden, deren Oberseite 49 in der Ebene 47 liegt.

Auf der Oberseite 49 der Leiterplatte 48 ist eine ringförmige Lötfläche 51 vorgesehen, die vom Durchmesser her dem Rand 44 entspricht. Innerhalb der ringförmigen Lötfläche 51 ist zentrisch eine Lötfläche 52 vorgesehen, die der Kontaktierung der Kontaktfläche 38 dient.

Weil der Schweißwinkel 46 leicht federt, lässt sich ein geringfügiger Überstand der Kontaktfläche 38 über die Ebene 47 durch leichten Druck ausgleichen. Auf diese Weise kann eine von der idealen Situation abweichende Lage des Schalters 10 in der Montagekappe 41 durch den Schweißwinkel 46 kompensiert werden.

Zwischen der ringförmigen Lötfläche 51 und der zentrischen Lötfläche 52 ist in der Leiterplatte 48 noch eine Entlüftungsbohrung 53 vorgesehen.

Wie bei SMD-Montage üblich, werden auf der ringförmigen Lötfläche 51 sowie auf der zentrischen Lötfläche 52 Lötpasten aufgebracht, woraufhin dann der Schalter 10 sozusagen kopfüber auf die Leiterplatte 48 so aufgelegt wird, dass sich die Lötpasten zwischen der ringförmigen Lötfläche 51 und dem Rand 44 sowie zwischen der zentrischen Lötfläche 52 und der Kontaktfläche 38 befinden.

Nach der üblichen Reflow-Technik werden die Lötflächen 51, 52 und Rand 44 sowie Kontaktfläche 38 jetzt miteinander verlötet. Dabei bildet sich zwischen der Leiterplatte 48 und dem Rand 44 ein Raum aus, der durch die Entlüftungsbohrung 53 entlüftet wird, so dass beim Verlöten keine mechanischen Störkräfte auftreten

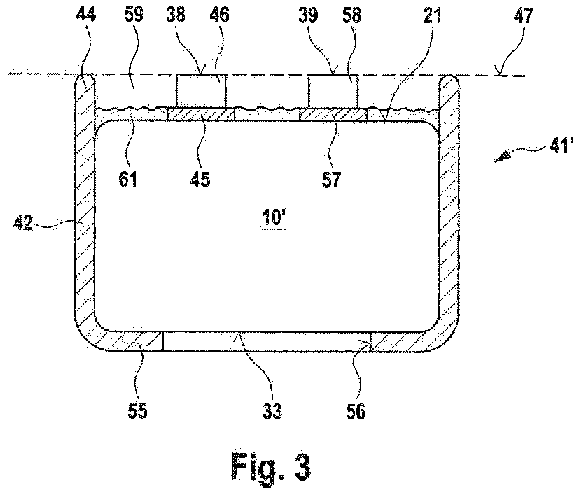

Während in Fig. 2 die Montagekappe 41 ringförmig ausgebildet ist, weist die in Fig. 3 gezeigte Montagekappe 41' einen Boden 55 mit einer zentrischen Öffnung 56 auf, die mindestens 50% der Unterseite 33 des Schalters 10' frei lässt, so dass eine gute thermische Anbindung zu dem zu schützenden Gerät sichergestellt ist.

Im äußeren Randbereich liegt die Unterseite 33 innen auf dem Boden 55 auf, wenn der hier gezeigte Schalter 10' bis zu diesem Anschlag in die Montagekappe 41' eingeschoben wurde. Auf diese Weise ergibt sich eine einfache und zuverlässige Positionierung des Randes 44 der Montagekappe 41' in Relation zu der Oberseite 21 des Schalters 10 bzw. zu dort vorgesehenen ersten äußeren Kontaktfläche 38.

Der Schalter 10' weist auf der Oberseite 21 die schon aus Fig. 2 bekannte erste Anschlussfläche 45 sowie eine zweite Anschlussfläche 57 auf. Auf beiden Anschlussflächen 45, 57 sind Distanzstücke 46 bzw. 58 positioniert, die als Schweißwinkel oder Klötze ausgebildet sein können. Auf dem zweiten Distanzstück 58 befindet sich die zweite äußere Kontaktfläche 39.

Der sich zwischen der Wand 42 der Montagekappe 41 und der Oberseite 21 ausbildende Raum 59 ist mit einem Dichtmittel 61 verfüllt, um den Eintrag von Schmutz und Feuchtigkeit in den Schalter 10' zu verhindern.

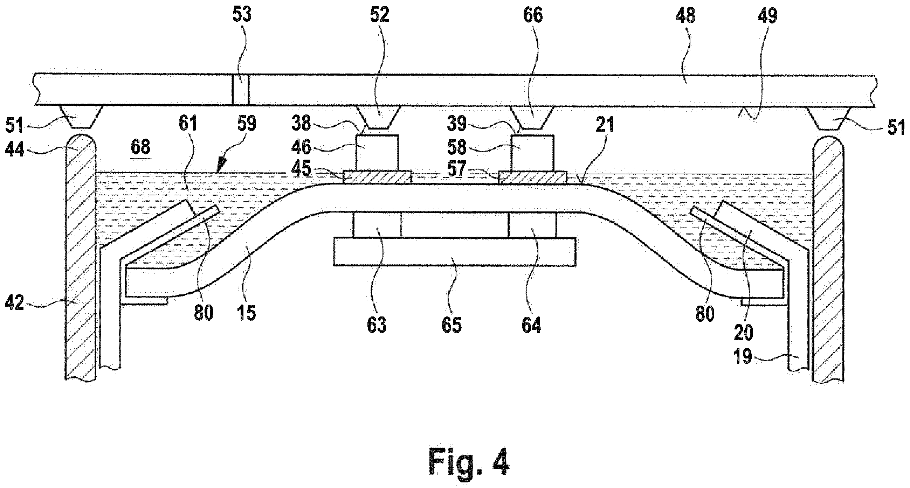

Während in den Fig. 1 und 2 ein Schalter 10 gezeigt ist, bei dem das temperaturabhängige Schaltwerk 11 ein bewegliches Kontaktteil 25 trägt, das in Anlage mit einem stationären Gegenkontakt 24 ist, der durch das Deckelteil 15 hindurch nach außen zu der ersten äußeren Kontaktfläche 38 kontaktiert ist, zeigen die Fig. 3 und 4 eine alternative Ausgestaltung eines Schalters 10', bei dem innen an dem Deckelteil 15 zwei stationären Gegenkontakte 63, 64 angeordnet sind.

Die beiden stationären Gegenkontakte 63, 64 wirken mit einem Stromübertragungsglied 65 zusammen, das von dem in Fig. 3 und 4 nicht gezeigten, temperaturabhängigen Schaltwerk bewegt wird.

Zwischen dem Deckelteil 15 und dem obere Abschnitt 20 der Wand 19 ist eine Dichtfolie 80 angeordnet, die für eine Abdichtung des Inneren des Schalters 10' sorgt. Diese Abdichtung wird durch das Dichtmittel 61 in dem Raum 59 noch unterstützt, das auch zwischen den Abschnitt 20, die Dichtfolie 80 und die Oberseite 21 gelangt, so dass sich ein hermetisch abgedichteter Schalter 10' ergibt.

Selbstverständlich kann das Dichtmittel 61 auch bei dem Schalter 10 aus den Fig. 1 und 2 in den Raum 59 zwischen der Wand 42 der Montagekappe 41 und der Oberseite 21 gegeben werden, um den Eintrag von Schmutz und Feuchtigkeit in den Schalter 10' zu verhindern. Dabei gelangt das Dichtmittel auch die Isolierfolien 13 und 22, so dass auch der Schalter 10 hermetisch abgedichtet wird.

Die beiden stationären Gegenkontakte 63, 64 wirken mit den beiden äußeren Anschlussflächen 45 und 57 zusammen, mit denen sie elektrisch verbunden sind. Auf den Anschlussflächen 45 und 57 sind wieder die Distanzstücke 46, 58 montiert, auf denen sich die Kontaktflächen 38, 39 befinden.

Auch der Schalter 10' wird nach SMD-Weise auf einer Leiterplatte 48 montiert, wie es in der ausschnittsweisen schematischen Seitenansicht der Fig. 4 zu sehen ist.

Auf der Oberseite 49 der Leiterplatte 48 ist neben den beiden Lötflächen 51 und 52 für den Rand 44 bzw. die erste Kontaktfläche 38 eine dritte Lötfläche 66 für die Kontaktfläche 39 vorgesehen, um den Schalter 10' elektrisch anzuschließen.

Die ringförmige Lötfläche 51 ist wieder für den Rand 44 vorgesehen, um den Schalter 10' mechanisch zu fixieren. Wenn der Rand 44 längs seines gesamten Umfanges mit der ringförmigen Lötfläche 51 verbunden ist, dient der Rand 44 als Barriere gegenüber dem Eintrag von Verunreinigungen.

Auch hier bildet sich zwischen der Leiterplatte 48 und dem Rand 44 ein Raum 68 aus, der durch die Entlüftungsbohrung 53 entlüftet wird, so dass beim Verlöten keine mechanischen Störkräfte auftreten.

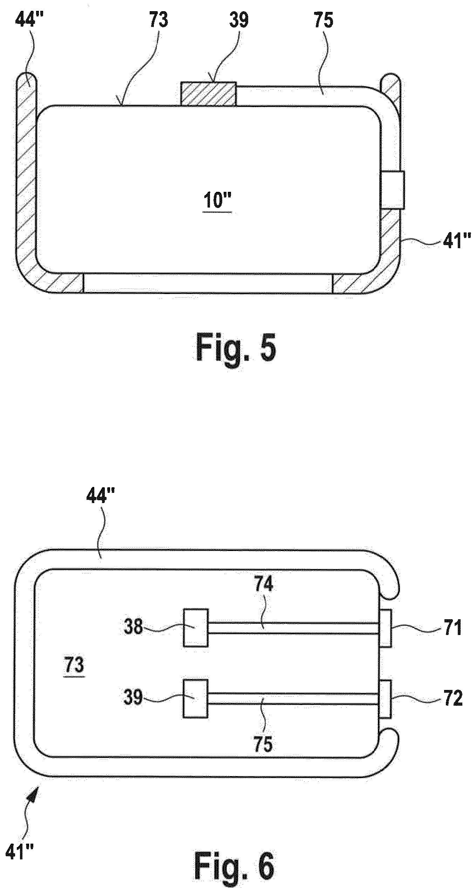

In Fig. 5 ist in einer Darstellung wie Fig. 2 und in Fig. 6 in Draufsicht eine Montagekappe 41" mit einem darin aufgenommenen temperaturabhängigen Schalter 10" gezeigt, bei dem zwei Anschlusskontakte 71, 72 seitlich aus dem Gehäuse 73 herausgeführt sind. Derartige Schalter sind zumeist flach und rechtwinklig, wie es aus der eingangs erwähnten DE 198 16 807 A1 bekannt ist.

Die beiden Anschlusskontakte 71, 72 sind über Verbindungen 74, 75 auf die Oberseite 76 des Gehäuses 73 geführt, wo sie mit den Kontaktflächen 38, 39 verbunden sind.

Die Montagekappe 41" weist wie der Schalter 10" eine rechtwinklige Form mit Seitenwänden 42" auf, die einen oberen Rand 44" aufweisen, der bei der SMT-Montage wie der Rand 44 in Fig.4 lediglich dem mechanischen Halt dient. Die Kontaktflächen 38, 39 werden mit entsprechenden Lötflächen auf einer Leiterplatte verbunden.

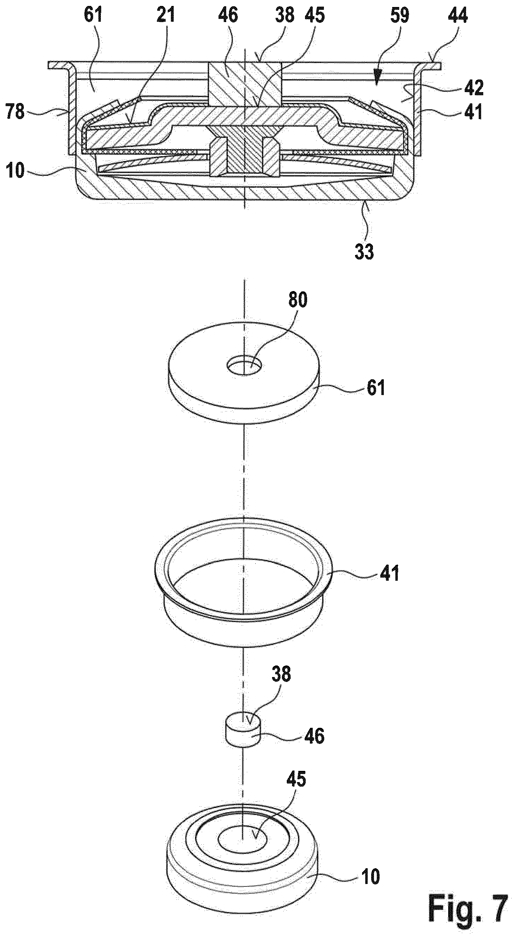

Fig. 7 zeigt einen vergleichbaren Schalter 10 wie in Fig. 1, nur in einer Montagekappe 41 angeordnet, und zwar oben in Fig. 7 in geschnittener Seitenansicht und unten in Fig. 7 in Explosionsdarstellung.

Der Rand 44 der Montagekappe 41 ist nach außen umgebogen und liegt in einer Ebene mit der Kontaktfläche 38 oben auf dem Distanzstück 46, das auf der ersten Anschlussfläche 45 festgelegt ist. Als zweite Anschlussfläche dient wie bei dem Schalter 10 aus Fig. 1 die Unterseite 33 des Schalters 10.

Wenn die Montagekappe 41 aus leitendem Material gefertigt ist, kann auch die Außenfläche 78 der Montagekappe 41 als zweite Anschlussfläche dienen.

Wie bei dem Schalter aus Fig. 4 ist auch bei dem Schalter 10 aus Fig. 7 ein Dichtmittel 61 in den Raum 59 zwischen der Wand 42 der Montagekappe 41 und der Oberseite 21 eingebracht, um den Eintrag von Schmutz und Feuchtigkeit in den Schalter 10' zu verhindern. Das Distanzstück 46 ragt durch das Dichtmittel 61 hindurch, das den gesamten Raum 59 hermetisch abdichtet.

Im Fig. 7 unten ist das erhärtete Dichtmittel 61 als Scheibe dargestellt, in der ein mittiges Loch 80 zu erkennen ist, durch das das Distanzstück 46 hindurchragt. Selbstverständlich wird das Dichtmittel 61 nicht als Scheibe bereitgestellt, es wird vielmehr in flüssiger Form in den Raum 59 eingebracht und erstarrt zu einer Scheibe. In Fig. 7 unten ist die Scheibe lediglich zur Verdeutlichung dargestellt.

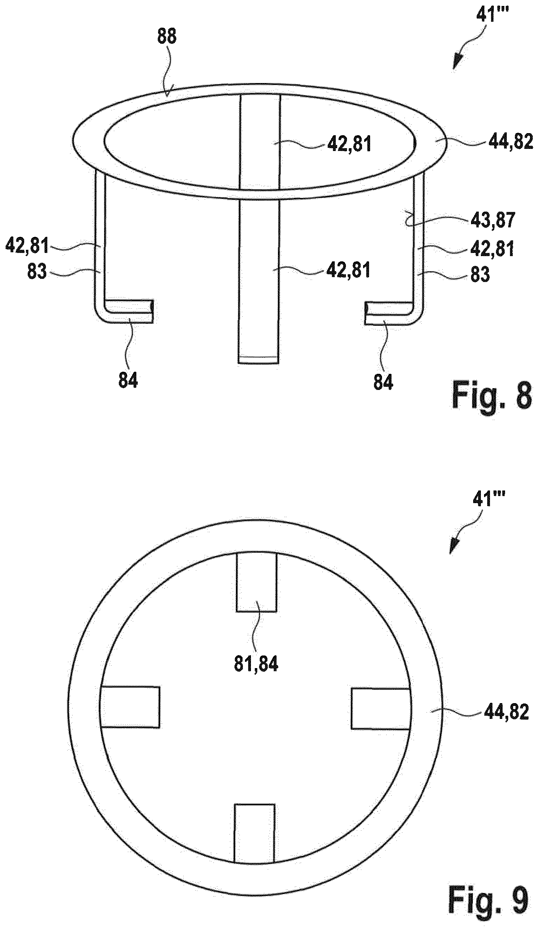

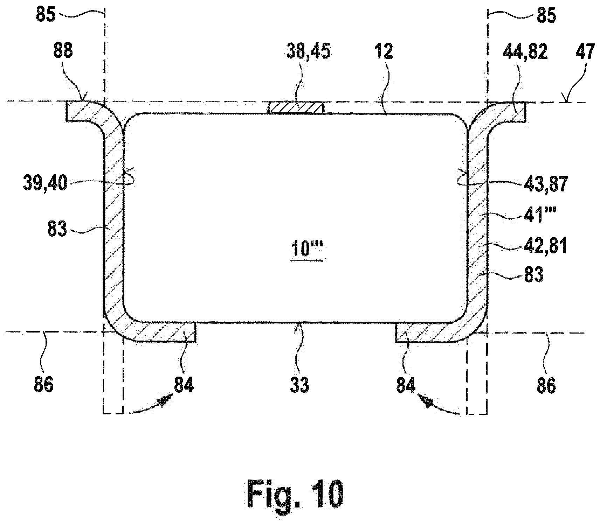

Fig. 8-10 zeigt ein weiteres Ausführungsbeispiel der Montagekappe 41‴. Fig. 8 und 9 zeigen die Montagekappe 41‴ ohne darin verbauten Schalter in einer perspektivischen Ansicht sowie in einer Draufsicht von oben. Fig. 10 zeigt die Montagekappe 41‴ mit dem darin verbauten Schalter 10‴ in einer schematischen Schnittansicht.

Die Montagekappe 41‴ hat im Gegensatz zu den Montagekappen 41, 41', 41" gemäß der zuvor beschriebenen Ausführungsbeispiele keine durchgehend geschlossene Wand 42. Stattdessen ist die Wand 42 der Montagekappe 41‴ unterbrochen ausgestaltet. Statt umfangsseitig geschlossen zu sein, weist diese Wand 42 mehrere Frei-, bzw. Zwischenräume auf.

Die Wand 42 wird hiervon mehreren Stegen 81 gebildet. In dem in Fig. 8-10 gezeigten Ausführungsbeispiel weist die Montagekappe 41‴ vier Stege 81 auf, die in Umfangsrichtung voneinander beabstandet sind. Jeder dieser Stege 81 ist im Querschnitt im Wesentlichen L-förmig. Die Stege 81 wirken als eine Art Krallen, die den Schalter 10‴ bzw. das Gehäuse 12 des Schalters 10‴, wie in Fig. 10 gezeigt, von außen halten. Die Stege 81 bilden gemeinsam eine Art korbförmige Halterung für den Schalter 10‴.

Die Stege 81 sind im Bereich ihres oberen Endes über einen Bund 82 miteinander verbunden. Dieser Bund 82 dient nicht nur der Verbindung der Stege 81 miteinander, er bildet den oberen Rand 44 der Montagekappe 41‴. Der Bund 82 ist im Wesentlichen ringförmig ausgestaltet. An seiner Oberseite weist er eine ringförmige Auflagefläche 88 auf, mithilfe derer die Montagekappe 41‴ per SMD-Montage an einer Leiterplatte, ähnlich wie zuvor bereits beschrieben, befestigbar ist.

Die Stege 81 weisen jeweils einen ersten Stegabschnitt 83 sowie einen zweiten Stegabschnitt 84 auf. Die ersten Stegabschnitte 83 der einzelnen Stege 81 verlaufen entlang mehreren, zueinander parallelen Achsen 85, die orthogonal zu der kreisringförmigen Auflagefläche 88 ausgerichtet sind.

Die ersten Stegabschnitte 83 stehen also nach unten hin von dem Bund 82 ab. Die zweiten Stegabschnitte 84 sind gegenüber den ersten Stegabschnitten 83 jeweils um etwa 90° abgewinkelt. Die zweiten Stegabschnitte 84 stehen radial nach innen von den ersten Stegabschnitten 83 ab. Die zweiten Stegabschnitte 84 liegen somit allesamt in einer gemeinsamen Ebene 86, die orthogonal zu den Achsen 85 der ersten Stegabschnitte 83 verläuft.

Wie insbesondere aus Fig. 10 ersichtlich ist, ist das Schalter-Gehäuse 12 des Schalters 10‴ wie in einer Art Korb in der Montagekappe 41‴ angeordnet. Die Innenseite 87 der ersten Stegabschnitte 83 liegt in montiertem Zustand vorzugsweise bündig an der Außenseite 40 des Schalter-Gehäuses 12 an. Die Innenseiten 87 der Stege 81 bilden mit anderen Worten gemeinsam die Innenseite 43 der hier unterbrochenen Wand 42 der Montagekappe 41‴, die umfangsseitig das Schalter-Gehäuse 12 abstützt.

An seiner Unterseite 33 wird das Schalter-Gehäuse 12 durch die zweiten Stegabschnitte 84 abgestützt. Die zweiten Stegabschnitte 84 liegen vorzugsweise bündig an der Unterseite 33 des Schalter-Gehäuses 12 an.

Die Höhe der Montagekappe 41‴ ist derart gewählt, dass die erste äußere Kontaktfläche 38 mit der auf der Oberseite des Bundes 82 vorgesehenen Auflagefläche 88 in einer gemeinsamen Ebene 47 liegt. Ein Höhenausgleich mithilfe von Distanzstücken 46, 58 oder mittels eines Schweißwinkels wie in den zuvor erwähnten Ausführungsbeispielen ist hier nicht notwendig. Der Schalter 10‴ lässt sich samt der Montagekappe 41‴ somit sehr einfach auf einer Leiterplatte anbringen, wobei während der SMD-Montage einerseits die erste äußere Kontaktfläche 38, die gleichzeitig die erste Anschlussfläche 45 bildet, mit einer Leiterbahn verlötet wird und die Auflagefläche 88 mit einer anderen Leiterbahn verlötet wird. Als zweiter äußere Kontaktfläche 39 dient die Außenseite 40 des Schalter-Gehäuses 12. Diese zweite äußere Kontaktfläche 39 ist über die metallische Montagekappe 41‴ elektrisch leitend mit der Auflagefläche 88 verbunden. Somit stellt der Schalter 10‴ auch hier temperaturabhängig über das Schaltwerk 11 eine elektrisch leitende Verbindung zwischen der Auflagefläche 88 und der ersten Anschlussfläche 45 her oder trennt diese. Da die Auflagefläche 88 und die erste Anschlussfläche 45 in ein und derselben Ebene 47 angeordnet sind, kann die SMD-Montage des Schalters 10‴ samt Montagekappe 41‴ sehr einfach erfolgen.Die Montage des Schalter-Gehäuses 12 innerhalb der Montagekappe 41‴ erfolgt vorzugsweise folgendermaßen: Im Rohzustand, also vor der Montage, sind die zweiten Stegabschnitte 84 noch nicht gegenüber den ersten Stegabschnitten 83 abgewinkelt. Dies ist in Fig. 10 gestrichelt angedeutet. Das Schalter-Gehäuse 12 lässt sich somit sowohl von oben als auch von unten in die Montagekappe 41‴, also in den Zwischenraum zwischen die Stege 81, einbringen. Vorzugsweise wird die Montagekappe 41‴ dazu über Kopf, also mit der Auflagefläche 88 auf eine Planfläche in einem Werkzeug aufgelegt. Der Schalter 10‴ wird dann in die Montagekappe 41‴ derart eingebracht, dass dieser mit der an dem Deckelteil 15 angeordneten ersten äußeren Kontaktfläche 38 ebenfalls auf der Planfläche im Werkzeug aufliegt. Die Auflagefläche 88 und die erste Anschlussfläche 45 sind damit automatisch relativ zueinander in einer Ebene 47 ausgerichtet. Anschließend werden die zweiten Stegabschnitte 84, wie durch die Pfeile in Fig. 10 angedeutet, umgebogen oder umgebördelt, so dass diese in Anlage mit der Unterseite 33 des Schalter-Gehäuses 12 gelangen. Vorzugsweise wird die Montagekappe 41‴ abschließend noch stoffschlüssig mit dem Schalter-Gehäuse 12 verbunden. Dies kann beispielsweise durch Verschweißen, Verlöten oder Verkleben der zweiten Stegabschnitte 84 mit der Unterseite 33 des Schalter-Gehäuses 12 erfolgen.

Montagekappe 41‴ und Schalter 10‴ bzw. Schalter-Gehäuse 12 sind also bereits vor der Anbringung auf einer Leiterplatte untrennbar miteinander verbunden und bilden eine gemeinsame Baueinheit, die sich als Schüttgut lagern lässt.

Im Vergleich zu den zuvor gezeigten Ausführungsbeispielen hat die in Fig. 8-10 gezeigte Montagekappe 41‴ aufgrund der flächenmäßig relativ kleinen Anlagefläche der Stege 81 an der Außenseite 40 des Gehäuses 12 den Vorteil, dass hierdurch der Übergangswiderstand erheblich reduziert wird. Zudem kann die Montagekappe 41‴ vergleichsweise leichtgewichtig ausgestaltet sein. Sie ist dennoch sehr einfach an dem Schalter-Gehäuse 12 montierbar.

Es versteht sich, dass auch ein Schalter 10', wie er in den Fig. 3 und 4 gezeigt wurde, in der Montagekappe 41‴ verbaubar ist. Ebenso ist es auch möglich, die Montagekappe 41‴ mehrteilig auszugestalten, also z.B. den Bund 82 und die Stege 81 als voneinander separate Bauteile zu realisieren, die miteinander stoffschlüssig verbunden sind. Eine Ausgestaltung des Bundes 82 sowie der ersten und zweiten Stegabschnitte 83, 84 als ein integrales Bauteil hat jedoch den Vorteil einer insgesamt größeren Stabilität.

Ebenso versteht es sich, dass die zweiten Stegabschnitte 84 nicht zwangsläufig kürzer ausgestaltet sein müssen als die ersten Stegabschnitte 83. Die zweiten Stegabschnitte 84 der einzelnen Stege 81 können auch radial weiter nach innen hineinragen und beispielsweise in der Mitte der Bodenfläche der Montagekappe 41‴ zusammenlaufen. Dann ergibt sich eine Art stern- bzw. kreuzförmig ausgestaltete Bodenfläche der Montagekappe 41‴.

## Patentansprüche

1. Vorrichtung, umfassend:
- einen temperaturabhängigen Schalter (10) mit einem Gehäuse (12), das eine Oberseite (21) und eine dazu quer verlaufende Außenseite (40) umfasst, mit zumindest einer auf der Oberseite (21) angeordneten ersten äußeren Kontaktfläche (38), zumindest einer außen an dem Gehäuse (12) angeordneten zweiten äußeren Kontaktfläche (39), und mit einem in dem Gehäuse (12) angeordneten temperaturabhängigen Schaltwerk (11), das in Abhängigkeit von seiner Temperatur eine elektrisch leitende Verbindung zwischen der ersten und der zweiten äußeren Kontaktfläche (38, 39) herstellt oder öffnet, und
- eine metallene Montagekappe (41), in der das Gehäuse (12) aufgenommen ist, wobei die Montagekappe (41) eine Wand (42) aufweist, deren oberer Rand (44) die Oberseite (21) des Gehäuses (12) überragt, und deren Innenseite (43) zumindest teilweise an der Außenseite (40) anliegt,
**dadurch gekennzeichnet, dass** der obere Rand (44) in einer Ebene (47) mit der ersten äußeren Kontaktfläche (38) liegt.

2. Vorrichtung nach Anspruch 1, **dadurch gekennzeichnet, dass** das Gehäuse (12) ein Deckelteil (15), an dem die Oberseite (21) ausgebildet ist, und ein Unterteil (14) aufweist, an dem die Außenseite (40) des Gehäuses (12) ausgebildet ist, wobei das Deckelteil (15) an dem Unterteil (14) gehalten ist.

3. Vorrichtung nach Anspruch 2, **dadurch gekennzeichnet, dass** die Innenseite (43) der Wand (42) der Montagekappe (41) vollflächig an der Außenseite (40) des Unterteils (14) anliegt.

4. Vorrichtung nach einem der Ansprüche 2 bis 3, **dadurch gekennzeichnet, dass** die zweite äußere Kontaktfläche (39) durch die Außenseite (40) des Unterteils (14) gebildet ist oder auf der Oberseite (21) des Deckelteils (15) angeordnet ist.

5. Vorrichtung nach einem der Ansprüche 1 bis 4, **dadurch gekennzeichnet, dass** das Gehäuse (12) klemmend in der Montagekappe (41) gehalten ist.

6. Vorrichtung nach einem der Ansprüche 1 bis 5, **dadurch gekennzeichnet, dass** die Montagekappe (41) einen Boden (55) aufweist, auf dem das Gehäuse (12) mit seiner Unterseite (33) aufliegt, und dass der Boden (55) vorzugsweise eine zentrische Öffnung (56) aufweist, die vorzugsweise mindestens 50% der Unterseite (33) freigibt

7. Vorrichtung nach einem der Ansprüche 1 bis 6, **dadurch gekennzeichnet, dass** der sich auf der Oberseite (21) des Gehäuses (12) zwischen der Wand (42) der Montagekappe (41) und der Oberseite (21) bildende Raum (59) mit einem Dichtmittel (61) verfüllt ist

8. Vorrichtung nach einem der Ansprüche 1 bis 7 **dadurch gekennzeichnet, dass** auf der Oberseite (21) des Gehäuses (12) zumindest eine erste Anschlussfläche (45) ausgebildet ist, mit der ein erstes Distanzstück (46) verbunden ist, an dem die erste äußere Kontaktfläche (38) ausgebildet ist.

9. Vorrichtung nach einem der Ansprüche 1 bis 8, **dadurch gekennzeichnet, dass** die Wand (42) der Montagekappe (41) unterbrochen ist.

10. Vorrichtung nach Anspruch 9, **dadurch gekennzeichnet, dass** die Montagekappe (41) mehrere, voneinander in Umfangsrichtung beabstandete Stege (81) aufweist, wobei eine dem Gehäuse (12) zugewandte Innenseite (87) der Stege (81) die Innenseite (43) der unterbrochenen Wand (42) der Montagekappe (41) bildet.

11. Vorrichtung nach Anspruch 10, **dadurch gekennzeichnet, dass** die Stege (81) im Querschnitt jeweils im Wesentlichen L-förmig sind.

12. Vorrichtung nach Anspruch 11, **dadurch gekennzeichnet, dass** die Stege (81) jeweils einen ersten Stegabschnitt (83), der an der Außenseite (40) des Gehäuses (12) anliegt, und einen zweiten Stegabschnitt (84), der gegenüber dem ersten Stegabschnitt (83) abgewinkelt ist und auf dem das Gehäuse (12) mit seiner Unterseite (33) aufliegt, aufweist, wobei die ersten Stegabschnitte (83) der Stege (81) sich vorzugsweise entlang zueinander paralleler Achsen (85) erstrecken und die zweiten Stegabschnitte (84) vorzugsweise in einer gemeinsamen Ebene (86) liegen, die quer zu den Achsen (85) der ersten Stegabschnitte (83) ausgerichtet ist.

13. Vorrichtung nach einem der Ansprüche 10-12, **dadurch gekennzeichnet, dass** zumindest einer der Stege (81) mit dem Gehäuse (12) stoffschlüssig verbunden ist.

14. Vorrichtung nach einem der Ansprüche 10-13, **dadurch gekennzeichnet, dass** die Stege (81) über einen im Wesentlichen ringförmigen Bund (82) miteinander verbunden sind, der an einer von den Stegen (81) abgewandten Oberseite eine im Wesentlichen kreisringförmige Auflagefläche (88) aufweist, die den oberen Rand (44) bildet.

15. Elektronische Schaltung mit zumindest einer auf einer Leiterplatte (48) montierten Vorrichtung nach einem der Ansprüche 1 bis 14, **dadurch gekennzeichnet, dass** der Rand (44) der metallenen Montagekappe (41) auf der Leiterplatte (48) aufliegt.

16. Elektronische Schaltung nach Anspruch 15, **dadurch gekennzeichnet, dass** die erste äußere Kontaktfläche (38) auf eine an der Leiterplatte (48) vorgesehene erste Lötfläche (52) zu weist und mit dieser verlötet ist, und dass der Rand (44) der Montagekappe (41) auf eine an der Leiterplatte (48) vorgesehene zweite Lötfläche (51) zu weist und mit dieser verlötet ist.

17. Elektronische Schaltung nach Anspruch 16, **dadurch gekennzeichnet, dass** die zweite Lötfläche (51) eine ringförmige Lötfläche ist, und der Rand (44) längs seines gesamten Umfanges durchgehend mit der zweiten Lötfläche (51) verlötet ist.

18. Elektronische Schaltung nach Anspruch 16 oder 17, **dadurch gekennzeichnet, dass** die zweite äußere Kontaktfläche (39) an dem Rand (44) angeordnet ist, oder dass die zweite äußere Kontaktfläche (39) an der Oberseite (21) des Deckelteils (15) angeordnet ist und mit einer an der Leiterplatte (48) vorgesehenen dritten Lötfläche (66) verlötet ist.

19. Elektronische Schaltung nach einem der Ansprüche 16 bis 18, **dadurch gekennzeichnet, dass** in der Leitplatte (48) eine Entlüftungsbohrung (53) vorgesehen ist, die in einen Raum (68) mündet, der zwischen der Leiterplatte (48) und dem Rand (44) ausgebildet ist.

## Claims

1. A device, including:
- a temperature-dependent switch (10) having a housing (12) which comprises a top side (21) and an outer side (40) which runs transversely to said top side, having at least one first outer contact area (38) which is arranged on the top side (21), at least one second outer contact area (39) which is arranged on an outside of the housing (12), and having a temperature-dependent switching mechanism (11) which is arranged in the housing (12) and, depending on its temperature, establishes or opens an electrically conductive connection between the first and the second outer contact area (38, 39), and
- a metal mounting cap (41), in which the housing (12) is received, wherein the metal mounting cap (41) comprises a wall (42), the upper rim (44) of which wall protrudes beyond the top side (21) of the housing (12), and the inner side (43) of which wall bears at least partially against the outer side (40)**characterized in that** the upper rim (44) lies in a plane (47) with the first outer contact area (38).

2. The device as claimed in claim 1, **characterized in that** the housing (12) comprises a cover part (15), on which the top side (21) is formed, and a bottom part (14), on which the outer side (40) of the housing (12) is formed, wherein the cover part (15) is held on the bottom part (14).

3. The device as claimed in claim 2, **characterized in that** the inner side (43) of the wall (42) of the mounting cap (41) bears against the outer side (40) of the bottom part (14) over its entire surface area.

4. The device as claimed in one of claims 2 to 3, **characterized in that** the second outer contact area (39) is formed by the outer side (40) of the bottom part (14) or arranged on the top side (21) of the cover part (15).

5. The device as claimed in one of claims 1 to 4, **characterized in that** the housing (12) is held in the mounting cap (41) in a clamping manner.

6. The device as claimed in one of claims 1 to 5, **characterized in that** the mounting cap (41) comprises a base (55) on which the housing (12) rests by way of its bottom side (33), and **in that** the base (55) preferably comprises a central opening (56) which preferably exposes at least 50% of the bottom side (33).

7. The device as claimed in one of claims 1 to 6, **characterized in that** the space (59) which forms on the top side (21) of the housing (12) between the wall (42) of the mounting cap (41) and the top side (21) is filled with a sealing means (61).

8. The device as claimed in one of claims 1 to 7, **characterized in that** at least one first connection area (45) is formed on the top side (21) of the housing (12), a first spacer (46) on which the first outer contact area (38) is formed being connected to said first connection area.

9. The device as claimed in one of claims 1 to 8, **characterized in that** the wall (42) of the mounting cap (41) is interrupted.

10. The device as claimed in claim 9, **characterized in that** the mounting cap (41) comprises a plurality of webs (81) which are spaced apart from one another in the peripheral direction, where an inner side (87) of the webs (81), which inner side faces the housing (12), forms the inner side (43) of the interrupted wall (42) of the mounting cap (41).

11. The device as claimed in claim 10, **characterized in that** the webs (81) are each substantially L-shaped in cross section.

12. The device as claimed in claim 11, **characterized in that** the webs (81) each comprise a first web section (83), which bears against the outer side (40) of the housing (12), and a second web section (84), which is angled in relation to the first web section (83) and on which the housing (12) rests by way of its bottom side (33), wherein the first web sections (83) of the webs (81) preferably extend along axes (85) which are parallel to one another, and the second web sections (84) preferably lie in a common plane (86) which is oriented transversely to the axes (85) of the first web sections (83).

13. The device as claimed in one of claims 10-12, **characterized in that** at least one of the webs (81) is cohesively connected to the housing (12).

14. The device as claimed in one of claims 10-13, **characterized in that** the webs (81) are connected to one another by means of a substantially annular collar (82) which, on a top side which is averted from the webs (81), comprises a substantially circular support area (88) which forms the upper rim (44).

15. An electronic circuit comprising at least one device as claimed in one of claims 1 to 14 which is mounted on a printed circuit board (48), **characterized in that** the rim (44) of the metal mounting cap (41) rests on the printed circuit board (48).

16. The electronic circuit as claimed in claim 15, wherein the first outer contact area (38) faces a first soldering area (52), which is provided on the printed circuit board (48), and is soldered to said first soldering area, and wherein the rim (44) of the mounting cap (41) faces a second soldering area (51), which is provided on the printed circuit board (48), and is soldered to said second soldering area.

17. The electronic circuit as claimed in claim 16, **characterized in that** the second soldering area (51) is an annular soldering area, and the rim (44), along its entire periphery, is continuously soldered to the second soldering area (51).

18. The electronic circuit as claimed in claim 16 or 17, **characterized in that** the second outer contact area (39) is arranged on the rim (44), or **in that** the second outer contact area (39) is arranged on the top side (21) of the cover part (15) and is soldered to a third soldering area (66) which is provided on the printed circuit board (48).

19. The electronic circuit as claimed in one of claims 16 to 18, **characterized in that** a ventilation bore (53) is provided in the printed circuit board (48), said ventilation bore issuing into a space (68) which is formed between the printed circuit board (48) and the rim (44).

## Revendications

1. Dispositif, comprenant :
- un commutateur dépendant de la température (10) avec un boîtier (12), qui comprend un côté supérieur (21) et un côté extérieur (40) s'étendant transversalement à celui-ci, avec au moins une première surface de contact extérieure (38) agencée sur le côté supérieur (21), au moins une deuxième surface de contact extérieure (39) agencée à l'extérieur du boîtier (12), et avec un mécanisme de commutation (11) dépendant de la température, agencé dans le boîtier (12), qui, en fonction de sa température, établit ou ouvre une liaison électriquement conductrice entre la première et la deuxième surface de contact extérieure (38, 39), et
- un capuchon de montage métallique (41) dans lequel est logé le boîtier (12), le capuchon de montage (41) présentant une paroi (42) dont le bord supérieur (44) dépasse du côté supérieur (21) du boîtier (12) et dont le côté intérieur (43) s'applique au moins partiellement sur le côté extérieur (40),
**caractérisé en ce que** le bord supérieur (44) est situé dans un plan (47) avec la première surface de contact extérieure (38).

2. Dispositif selon la revendication 1, **caractérisé en ce que** le boîtier (12) présente une partie couvercle (15) sur laquelle est réalisé le côté supérieur (21) et une partie inférieure (14) sur laquelle est réalisé le côté extérieur (40) du boîtier (12), la partie couvercle (15) étant maintenue sur la partie inférieure (14).

3. Dispositif selon la revendication 2, **caractérisé en ce que** le côté intérieur (43) de la paroi (42) du capuchon de montage (41) s'applique sur toute sa surface sur le côté extérieur (40) de la partie inférieure (14).

4. Dispositif selon l'une quelconque des revendications 2 à 3, **caractérisé en ce que** la deuxième surface de contact extérieure (39) est formée par le côté extérieur (40) de la partie inférieure (14) ou est agencée sur le côté supérieur (21) de la partie couvercle (15).

5. Dispositif selon l'une quelconque des revendications 1 à 4, **caractérisé en ce que** le boîtier (12) est maintenu par serrage dans le capuchon de montage (41).

6. Dispositif selon l'une quelconque des revendications 1 à 5, **caractérisé en ce que** le capuchon de montage (41) présente un fond (55) sur lequel repose le boîtier (12) par son côté inférieur (33), et **en ce que** le fond (55) présente de préférence une ouverture centrale (56) qui libère de préférence au moins 50 % du côté inférieur (33).

7. Dispositif selon l'une quelconque des revendications 1 à 6, **caractérisé en ce que** l'espace (59) se formant sur le côté supérieur (21) du boîtier (12) entre la paroi (42) du capuchon de montage (41) et le côté supérieur (21) est rempli d'un produit d'étanchéité (61).

8. Dispositif selon l'une quelconque des revendications 1 à 7, **caractérisé en ce que** sur le côté supérieur (21) du boîtier (12) est réalisée au moins une première surface de raccordement (45) à laquelle est reliée une première pièce d'écartement (46) sur laquelle est réalisée la première surface de contact extérieure (38).

9. Dispositif selon l'une quelconque des revendications 1 à 8, **caractérisé en ce que** la paroi (42) du capuchon de montage (41) est interrompue.

10. Dispositif selon la revendication 9, **caractérisé en ce que** le capuchon de montage (41) présente plusieurs entretoises (81) espacées les unes des autres dans la direction circonférentielle, un côté intérieur (87) des entretoises (81) tourné vers le boîtier (12) formant le côté intérieur (43) de la paroi interrompue (42) du capuchon de montage (41).

11. Dispositif selon la revendication 10, **caractérisé en ce que** les entretoises (81) ont chacune une section transversale essentiellement en forme de L.

12. Dispositif selon la revendication 11, **caractérisé en ce que** les entretoises (81) présentent chacune une première section d'entretoise (83) qui s'applique sur le côté extérieur (40) du boîtier (12) et une deuxième section d'entretoise (84) qui est coudée par rapport à la première section d'entretoise (83) et sur laquelle le boîtier (12) repose par son côté inférieur (33), les premières sections d'entretoise (83) des entretoises (81) s'étendant de préférence le long d'axes (85) parallèles entre eux et les deuxièmes sections d'entretoise (84) étant de préférence situées dans un plan commun (86) qui est orienté transversalement aux axes (85) des premières sections d'entretoise (83).

13. Dispositif selon l'une quelconque des revendications 10 à 12, **caractérisé en ce qu'**au moins l'une des entretoises (81) est reliée au boîtier (12) par liaison de matière.

14. Dispositif selon l'une quelconque des revendications 10 à 13, **caractérisé en ce que** les entretoises (81) sont reliées entre elles par l'intermédiaire d'une collerette (82) essentiellement annulaire qui présente, sur un côté supérieur détourné des entretoises (81), une surface d'appui (88) essentiellement en forme d'anneau de cercle qui forme le bord supérieur (44).

15. Circuit électronique avec au moins un dispositif selon l'une quelconque des revendications 1 à 14, monté sur une carte de circuit imprimé (48), **caractérisé en ce que** le bord (44) du capuchon de montage métallique (41) repose sur la carte de circuit imprimé (48).

16. Circuit électronique selon la revendication 15, **caractérisé en ce que** la première surface de contact extérieure (38) est orientée vers et soudée à une première surface de soudure (52) prévue sur la carte de circuit imprimé (48), et **en ce que** le bord (44) du capuchon de montage (41) est orienté vers et soudé à une deuxième surface de soudure (51) prévue sur la carte de circuit imprimé (48).

17. Circuit électronique selon la revendication 16, **caractérisé en ce que** la deuxième surface de soudure (51) est une surface de soudure annulaire et le bord (44) est soudé à la deuxième surface de soudure (51) de manière continue le long de toute sa circonférence.

18. Circuit électronique selon la revendication 16 ou 17, **caractérisé en ce que** la deuxième surface de contact extérieure (39) est agencée sur le bord (44), ou **en ce que** la deuxième surface de contact extérieure (39) est agencée sur le côté supérieur (21) de la partie couvercle (15) et est soudée à une troisième surface de soudure (66) prévue sur la carte de circuit imprimé (48).

19. Circuit électronique selon l'une quelconque des revendications 16 à 18, **caractérisé en ce qu'**il est prévu dans la carte de circuit imprimé (48) un trou d'évent (53) qui débouche dans un espace (68) réalisé entre la carte de circuit imprimé (48) et le bord (44).
